# EUROPEAN PATENT SPECIFICATION

(11) **EP 4 456 435 B1**
(45) Date of publication and mention of the grant of the patent: **07.10.2026**
(21) Application number: 23170800.9
(22) Date of filing: 28.04.2023
(51) Int. Cl.: H03M 7/30

(54) **TRANSMITTING SENSOR DATA IN DISTRIBUTED SENSOR NETWORKS**
ÜBERTRAGUNG VON SENSORDATEN IN VERTEILTEN SENSORNETZWERKEN
TRANSMISSION DE DONNÉES DE CAPTEUR DANS DES RÉSEAUX DE CAPTEURS RÉPARTIS

(43) Date of publication of application: 30.10.2024
(73) Proprietor: Robert Bosch GmbH, 70442 Stuttgart (DE)
(72) Inventor: Gherekhloo, Soheil, 74348 Lauffen Am Neckar (DE); Chubanov, Sergei, 70197 Stuttgart (DE)

(56) References cited:
- EP-A1- 3 287 949
- KIM MYUNG-JUN ET AL: "Object Detection-Based Video Compression", APPLIED SCIENCES, vol. 12, no. 9, 29 April 2022 (2022-04-29), pages 4525, XP093086156, DOI: 10.3390/app12094525
- KONG LINGCHAO ET AL: "Object-Detection-Based Video Compression for Wireless Surveillance Systems", IEEE MULTIMEDIA, IEEE SERVICE CENTER, NEW YORK, NY, US, vol. 24, no. 2, 1 April 2017 (2017-04-01), pages 76 - 85, XP011649059, ISSN: 1070-986X, [retrieved on 20170510], DOI: 10.1109/MMUL.2017.29
- YUVAL SHALEV ET AL: "Neural Joint Entropy Estimation", ARXIV.ORG, CORNELL UNIVERSITY LIBRARY, 201 OLIN LIBRARY CORNELL UNIVERSITY ITHACA, NY 14853, 21 December 2020 (2020-12-21), XP081843313
- NGUYEN DAT THANH ET AL: "Lossless Point Cloud Geometry and Attribute Compression Using a Learned Conditional Probability Model", IEEE TRANSACTIONS ON CIRCUITS AND SYSTEMS FOR VIDEO TECHNOLOGY, 11 March 2023 (2023-03-11), pages 4337 - 4348, XP093084503, Retrieved from the Internet <URL:https://arxiv.org/pdf/2303.06519.pdf> DOI: 10.1109/TCSVT.2023.3239321

## Description

### Field of the invention

The invention relates to a computer-implemented method of encoding sensor data for transmission to a receiver. The invention further relates to a sender device. The invention further relates to a computer-implemented method of decoding sensor data received from a sender. The invention further relates to a receiver device. The invention further relates to a computer-readable medium comprising instructions for a processor system to perform any one of the computer-implemented methods, and to a distributed sensor network comprising the sender device and the receiver device.

### Background of the invention

Distributed sensor networks are typically comprised of multiple, physically separated sensors that collect data from their environment. The acquired sensor data may be exchanged for further processing, which may be performed centrally in a single node of the sensor network or in a distributed manner across multiple nodes. Distributed sensor networks offer various advantages, such as an extended field of view and increased accuracy of perception, making them particularly beneficial for safety-critical applications like autonomous driving. Exchanging data between distributed nodes may require reliable communication, and in many cases, low latency.

Several approaches are known for the transmission of acquired sensor data from a sensor device to a receiver device, such as the aforementioned central processing node, such as raw-sensor-data sharing (RDS) and object-based sensor data sharing (ODS). In RDS, the sensor data captured by the sensors may be transmitted in its directly acquired form or after limited post-processing (e.g., demosaicing of camera data). The types of shared data may depend on the sensors used, such as delay-Doppler spectrum data for radar, point cloud data for lidar, and image data from cameras. RDS may provide the receiver device with access to (nearly) all the information acquired by the sensor, which in turn may allow the sensor data to be processed with high accuracy, e.g., to recognize and track objects. However, RDS may need high communication bandwidth to maintain low latency and high reliability, which may not always be satisfied by communication technology, particularly in dense sensor networks.

In ODS, objects and their attributes are first extracted by the sensor devices and then transmitted to other node(s). The interface for exchanging objects in ODS is typically domain specific. For instance, in automotive, the so-called collective perception message (CPM) is used in which objects together with their state vectors including the entities such as position, velocity, acceleration, etc., and the accuracy of the measurements are encoded. ODS may have the disadvantage that some useful data may be lost and cannot be considered by the receiver device. One example is an object which is not detectable in the sensor data of individual sensor devices, e.g., by there being insufficient information in the individual sensor data for such detection or the sensor device lacking the required computational performance. In such cases, the receiver device is also not able to detect the object, while with RDS, the receiver device may be able to detect the object in the received sensor data and act thereupon.

Document by KIM MYUNG-JUN ET AL: "Object Detection-Based Video Compression" (APPLIED SCIENCES, vol. 12, no. 9, 29 April 2022, page 4525, DOI: 10.3390/app12094525) discloses object detection-based video compression encoding that allocates lower quantization parameters to the detected-object regions and higher quantization parameters to the background.

### Summary of the Invention

It would be desirable to provide methods and devices to address disadvantages of raw-sensor-data sharing (RDS) and object-based sensor data sharing (ODS).

In accordance with a first aspect of the invention, as defined by respectively claims 1 and 13, a computer-implemented method and a corresponding sender device are provided for encoding sensor data for transmission to a receiver. In accordance with a further aspect of the invention, as defined by respectively claims 11 and 14, a computer-implemented method and a corresponding receiver device are provided for decoding sensor data received from a sender. In accordance with a further aspect of the invention, a computer-readable medium is provided as defined by claim 12. In accordance with a further aspect of the invention, as defined by claim 15, a distributed sensor network is provided comprising the sender device and the receiver device.

The above measures involve accessing sensor data which is captured by a sensor. The sensor data may for example be image data acquired by an image sensor, lidar data acquired by a lidar sensor, radar data acquired by a radar sensor, etc. The sensor data may pertain to a physical environment and the physical environment may include one or more objects. For example, captured image data may show a road which may include road users, such as cars, bicyclists, pedestrians, etc. Such and other types of objects may be detected in the sensor data using an object detection technique. Object detection techniques are known per se in various application areas and may, but do not need to, be, based on machine learning. As a result of applying the object detection technique to the sensor data, one or more objects may be detected in the sensor data. Typically, in addition to indicating that an object is present in the sensor data, the object detection technique may also determine one or more attributes of the object. Such attributes may for example include object characteristics such as a position and/or size of the object, but may also include the type of object which is detected, e.g., whether the detected object is a car or a bicycle or a pedestrian. The detection of the type of object may also be referred to as a classification, in which the types of objects may be represented by respective object classes, for example the class 'car' for cars, 'bicycle' for bicycles, 'pedestrian' for pedestrians, etc. Such object detection techniques are known per se.

The above measures further involve encoding the sensor data to obtain encoded sensor data and sending the encoded sensor data to a receiver. Such transmission of the encoded sensor data typically takes place via a communication channel. An example of a communication channel is a wired or wireless network. The encoding of the sensor data may comprise the use of a data compression technique to reduce the size of the sensor data. Such data compression is in general known. For example, US4122440A describes an arithmetic coding scheme. Through a series of iterative steps, the algorithm generates a single number within a predefined range, representing the compressed data. It is said that this iterative approach allows for a compact representation of data.

In accordance with the above measures, the data compression technique which is used to compress the sensor data is configurable by one or more compression parameters. As such, the data compression technique may be reconfigured by the sender. Such reconfiguration may in general allow the data compression to be adapted, for example to the characteristics of the data to be compressed. In accordance with the above measures, and unlike US4122440A, the one or more compression parameters to be used for the encoding of a particular instance of sensor data are selected based on the one or more attributes of the object which is detected in this instance of sensor data. This way, the data compression technique may be adapted to the object contained in the sensor data. For example, different compression parameters may be selected for different types, e.g., different classes, of objects. The one or more attributes of the object may additionally be encoded by the sender in the form of object data, which object data may be sent to the receiver together with the encoded sensor data, e.g., in a same data container or separately but linked to the encoded sensor data.

The receiver may use a data decompression technique when decoding the encoded sensor data. As in the case of the data compression technique used by the sender, the data decompression technique used by the receiver may be configurable by one or more decompression parameters. These data decompression parameters may, but do not need to, correspond in type to the configurable compression parameters. As the receiver is provided with the object data, the receiver may, when applying the data decompression technique to the encoded sensor data, select the decompression parameter(s) of the data decompression technique based on the one or more attributes of the object. This way, the receiver may correctly decode the encoded sensor data.

The above measures have the effect that the data compression is made adaptive to attributes of the object detected in the particular instance of sensor data to be encoded, e.g., to a particular camera image, lidar scan result, radar scan result, etc. This way, the data compression may be optimized for the particular instance of sensor data. Namely, the sensor data of different types of objects, or in general the sensor data of objects having different attributes, may differ in its characteristics and may be better compressed when data compression parameter(s) of the data compression technique are adapted to these object characteristics. To enable the receiver to correctly decode the encoded sensor data, the aforementioned object data is provided to receiver.

Advantageously, compared to ODS, the sensor data is provided to the receiver, which may avoid useful data from being lost and not being considered by the receiver. Compared to RDS, due to the object-adapted data compression, the transmitted data may be smaller in size and require less bandwidth to be transmitted. This way, a hybrid encoding scheme may be provided which may combine advantages of ODS and RDS.

The following optional aspects of the invention may be described with reference to the encoding of the sensor data but will be understood by the skilled person to indicate technically corresponding optional aspects of the decoding of the sensor data.

According to the claimed invention, applying the data compression technique to the sensor data comprises:
- processing the sensor data to consecutively identify data patterns in the sensor data and convert each respective data pattern into a symbol selected from an auxiliary alphabet, thereby obtaining a string of symbols representing the sensor data;
- encoding the string of symbols to obtain a binary representation of the string of symbols, wherein the encoding uses a decision pattern for decision-making in the encoding, wherein the decision pattern is selected based on the one or more attributes of the object, for example by selecting a different decision pattern for different values of an attribute of the object.

A particular instance of sensor data, which may for example be comprised of an array of real or complex numbers, may be converted into a string of symbols defined in an auxiliary alphabet. This way, two or higher dimensional data may be converted into a one dimensional string of symbols to be further encoded. This encoding, and typically any type of encoding of data, may involve decision-making. In accordance with the above measures, a decision pattern is used for the decision-making. As is known per se, a decision pattern may indicate one or more decision paths to be followed during the encoding to arrive at a decision for the encoding. In accordance with the above measures, the decision pattern may be selected based on the one or more attributes of the object. This selection of the decision pattern may be an example of the aforementioned selecting of one or more data compression parameters and may allow the decision pattern may be made adaptive to the characteristics of the object in the particular instance of sensor data. For example, the different decision pattern may be selected for different values of one or more attributes of the object.

Optionally, encoding the string of symbols comprises using the decision pattern recursively for respective symbols. The decision pattern may be used recursively to encode consecutive symbols from the string of symbols.

Optionally, encoding the string of symbols comprises generating a complex number to represent at least a substring of the string of symbols, wherein the decision pattern is representable as a set of areas in a 2D coordinate system, each area from the set of areas representing a different symbol from the auxiliary alphabet, wherein the complex number is selected by recursively:
- selecting an area from the set of areas corresponding to a current symbol of the substring;
- partitioning said selected area to obtain a set of subareas corresponding to an geometric arrangement of areas in the set of areas; and
- selecting a subarea from the set of subareas corresponding to a next symbol of the substring;
   wherein the complex number to represent the substring is selected based on a coordinate in the 2D coordinate system of a last subarea selected for a last symbol of the substring, for example based on a centroid of the last subarea; and
- optionally, generating a binary representation of the complex number for transmission to the receiver.

The above measures define a graphical two-dimensional decision pattern which may be used recursively to select a complex number to represent a substring of the string of symbols, or in some embodiments to select a complex number to represent the entire string of symbols. This complex number may then be transmitted, for example in binary or in any other form, to the receiver. To determine the complex number, a set of areas may be provided in a 2D coordinate system, with each area corresponding to a different symbol from the auxiliary alphabet. A particular substring may then be converted into a complex number by selecting the area corresponding to a first symbol from the substring, then repartitioning the selected area to reestablish the set of areas as a set of subareas within the selected area, and then continuing the selection and repartitioning until arriving at a last symbol from the substring. This way, a last subarea may be selected for the last symbol of the substring, with the coordinates of the last subarea being used to determine the complex number. For example, a centroid of the last subarea may be used to determine the complex number, with the x-coordinate of the centroid determining the real part of the complex number and the y-coordinate of the centroid determining the imaginary part of the complex number. It may be advantageous to transmit the string of symbols as a complex number as the complex number may be selected in an interior of the last subarea in a way that achieves optimal data reduction, for example by selecting a complex number within the last subarea which has a minimum bit length of its binary representation in a given complex base. Nevertheless, the transmitted complex number may be decodable to the substring of symbols and therefore recoverable at the receiver. Namely, when decoding the encoded sensor data, a complex number may again be converted into a (sub)string of symbols by following the above-described process in reverse, e.g., by determining in which area from the set of areas the complex number falls and thereby determining a first symbol of the substring, then repartitioning the selected area to reestablish the set of areas as a set of subareas within the selected area, then determining in which subarea the complex number falls and thereby determining a next symbol, and then continuing the determining and repartitioning for a number of iterations to obtain the substring.

Optionally, the computer-implemented method for encoding sensor data further comprises, and/or a processor subsystem of the sender device is further configured for:
- determining a frequency of a respective data pattern in the sensor data to obtain a frequency of a corresponding symbol from the auxiliary alphabet; and
- determining a relative size of each area in the set of areas based on the frequency, for example proportionally to the frequency.

Optionally, the computer-implemented method for encoding sensor data further comprises, and/or a processor subsystem of the sender device is further configured for initially selecting a relative size of each area in the set of areas to be equal and adjusting the relative size during the encoding based on observed frequencies of respective data patterns.

Optionally, the computer-implemented method for encoding sensor data further comprises, and/or a processor subsystem of the sender device is further configured for selecting the auxiliary alphabet using a machine learning technique, wherein the machine learning technique is trained to select respective symbols of the auxiliary alphabet so that a binary representation of the string of symbols has a minimum binary length in a complex base in which the binary representation of the complex number is generated.

Optionally, the computer-implemented method for encoding sensor data further comprises, and/or a processor subsystem of the sender device is further configured for selecting a complex base in which a binary representation of the complex number is generated using a machine learning technique, wherein the machine learning technique is trained to select the complex base so that the binary representation of the complex number has a minimum binary length in the complex base.

Optionally, the object detection technique is configured to detect and classify the object in the sensor data to obtain an object classification as an attribute of the object.

Optionally, the sensor data comprises or is representable as a series or an array of complex numbers, for example in the form of a magnitude and a phase.

Optionally, the sensor data comprises or is an array of sensor data elements, for example in the form of an image.

It will be appreciated by those skilled in the art that two or more of the above-mentioned embodiments, implementations, and/or optional aspects of the invention may be combined in any way deemed useful.

Modifications and variations of any device, system, network, computer-implemented method and/or any computer readable medium, which correspond to the described modifications and variations of another of such entities, can be carried out by a person skilled in the art on the basis of the present description.

### Brief description of the drawings

These and other aspects of the invention will be apparent from and elucidated further with reference to the embodiments described by way of example in the following description and with reference to the accompanying drawings, in which:
Fig. 1 shows a hybrid sensor data compression scheme in which an object and one or more attributes of the object are detected in sensor data and in which the sensor data is encoded using a data compression scheme steered by the object attribute(s);
Fig. 2 shows an encoding graph which may be used in the encoding of the sensor data;
Fig. 3A illustrates how a static decision pattern may map coordinates in a 2D coordinate system to symbols of an auxiliary alphabet, wherein the static decision pattern partitions an area into a set of areas each representing a symbol from the auxiliary alphabet;
Figs. 3B-3D illustrate how a point in the 2D coordinate system may be converted into a series of symbols and vice versa on the basis of a recursive partitioning of an area which comprises the point by the arrangement of areas defined by the static decision pattern;
Fig. 4 shows a data exchange between a sender device and a receiver device;
Fig. 5 shows a method of encoding sensor data for transmission to a receiver;
Fig. 6 shows a method of decoding sensor data received from a sender; and
Fig. 7 shows a computer-readable medium comprising data.

It should be noted that the figures are purely diagrammatic and not drawn to scale. In the figures, elements which correspond to elements already described may have the same reference numerals.

### List of reference numbers and abbreviations

The following list of reference numbers is provided for facilitating the interpretation of the drawings and shall not be construed as limiting the claims.
- 50: communication channel

- 100: sender device
- 110: sensor
- 112: sensor data
- 114: delay [µs]
- 116: Doppler frequency [Hz]
- 120: sensor interface
- 140: processor subsystem
- 150: object detection function
- 152: detected object and object attributes (class)
- 154: object data
- 160: data compression function
- 180: communication interface
- 182: sensor data + object data

- 200: receiver device
- 220: communication interface
- 240: processor subsystem

- 300: set of areas representing static decision pattern
- 310: selected area
- 320: repartitioning of selected area
- 330: further repartitioning of further selected area

- 400: method of encoding sensor data for transmission to receiver
- 410: obtaining sensor data acquired by sensor
- 420: applying object detection technique to sensor data
- 430: encoding sensor data using data compression technique
- 440: generating object data
- 450: sending encoded sensor data and object data to receiver

- 500: method of decoding sensor data received from sender
- 510: receiving encoded sensor data from sender
- 520: receiving object data
- 530: decoding encoded sensor data based on object data

- 600: computer-readable medium (memory card)
- 610: stored data

### Detailed description of embodiments

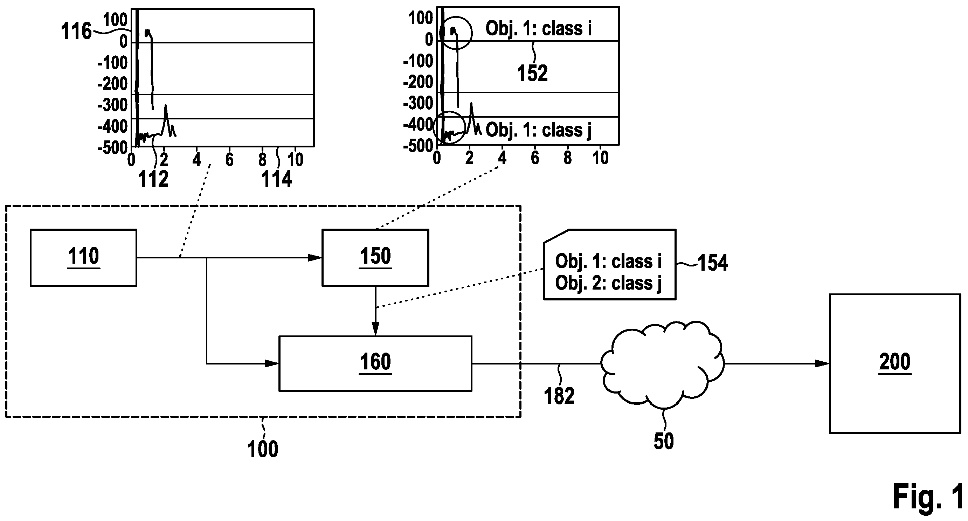

**Fig. 1** shows a hybrid sensor data compression scheme in which a sender device 100 comprises or is connected to a sensor 110 to access sensor data acquired by the sensor. In the example of Fig. 1, the sensor data is radar data 112 which may be visualized as an image having on one axis the delay [µs] 114 and on the other axis the Doppler frequency [Hz] 116. The sender device 100 may be configured to apply an object detection technique to the sensor data 112 to detect one or more objects in the sensor data, which is shown in Fig. 1 by an object detection function 150 detecting two objects 152 and one or more attributes of the objects. In this and other examples, an object attribute may be an object class, e.g., as obtained from a classification of the object, being in this example class i for object 1 and class j for object 2. The object detection function 150 may generate object data 154 which is indicative of the objects and their attribute(s), being in this example the object class. Such object data may take any suitable form, including XML, json, a binary format, etc. Both the sensor data 112 and the object data 154 may be input into a data compression function 160 which may compress the sensor data 112 using the object data 154. In particular, the data compression technique used by the data compression function 160 may configurable by one or more compression parameters, and the object attribute(s), being in this example the object class, may determine the value of the one or more compression parameters. As a result, encoded sensor data may be obtained which may be provided together with the object data as data 182 to a receiver device, e.g., via a communication channel 50.

The following describes a specific example of the encoding of the sensor data. In this specific example, the sensor data is assumed to be complex data, such as the aforementioned radar data in which, for each delay and Doppler frequency instant, a complex number describes the attenuation and phase of the channel. However, this is not a limitation, in that the sensor data may also be comprised of real numbers.

One may consider the sensor data to represent or be representable as a matrix M of complex numbers whose real and imaginary parts are integers ranging from 0 to u. Such a matrix may for example represent an image or any other instance of sensor data. For each matrix, object detection may be used to determine the classes of objects represented in the matrix. One may assume that there are in general c classes enumerated by indices in [*c*] = {1, *... , c*}. The presence of a class of objects in M may be encoded by a binary vector *b* ∈ {0,1}*^{c}* whose lth component is 1 when M contains an object of the lth class. If nothing is known about the object classes represented in M, or if such object classes are simply not present in *M,* then the respective binary vector may be zero. It is noted that the information about object classes may also be available in the form of a probability distribution over [*c*]. In this case, one may draw an index *l* for each object from the respective distribution. The obtained set of class indices, one per object, may then be used to construct the mentioned binary vector *b.*

When encoding a respective instance of sensor data, and thus *M,* a goal may be to represent *M* with a minimum possible number of binary digits, which number may preferably be smaller than the initial size of the sensor data to be encoded. The following provides a specific example of an encoding of *M* and a subsequent decoding. In this example, a different decision pattern is selected for the encoding and decoding depending on the object class of the detected object. It will be appreciated, however, that also other compression parameter(s) may be selected based on other object attributes as this may equally establish an object-adaptive encoding of the sensor data.

Let *vect*(*M*) be the complex vector enumerating the entries of *M* in a column-wise manner. Each entry of *M* may be represented in the form ${\sum }_{j = 0}^{\left⌈{log}_{2}u\right⌉} {2}^{j} {q}_{j}$ where *qⱼ* belong to *Q* = {0,1, *i,* 1 *+ i*}. Therefore, *vect*(*M*) may be represented as a *Q*-vector that may be denoted by *vect_{Q}*(*M*) and which may be partitioned in fixed-size series, of symbols of Q, each comprising $\left⌈{log}_{2}u\right⌉$ components representing the respective component of *vect*(*M*). The *Q*-vector representing *M* may contain repeated patterns which may be recognized and encoded as respective symbols of an auxiliary alphabet Σ.

The auxiliary alphabet Σ may be chosen in various ways. One may generally assume that *Q* ⊆ Σ. (For the initial choice of Σ, one can also include series *q* ··· *q*, for each *q* ∈ *Q*, whose lengths are powers of 2, up to a given length not greater than the dimension of *vect*(*M*).) One may further assume, without loss of generality, that all input matrices are of the same size, which means that the number *n* of symbols of *Q* in *vect_{Q}*(*M*) may be fixed. In examples in which different instances of sensor data may have different matrix shapes, an additional symbol "ED" may be introduced having the meaning "end of data". In such examples, each encoding string may end with "ED", which can be used by the encoder to determine when to stop.

Each of the *n* positions of a *Q* vector with *n* components may be associated with a weight. For position *j*, the weight may be computed as ${2}^{j mod \left⌈{log}_{2}u\right⌉}$. Let the respective weight be denoted by *ωⱼ.* Let *x* be a string over Σ representing *z*' ∈ *Qⁿ.* By the weighted error with which *x* represents another *z* ∈ *Qⁿ* the following may be meant: the sum of weights of the components in which *z'* differs from *z* divided by the total weight of components of a vector in *Qⁿ.* Let *z_{k,t}* denote (*zₖ, ... , zₜ*)*.* The weighted error with which *z_{k,t}* may be represented by a symbol *a* ∈ Σ is the sum of the weights in {*ωₜ*: *i* ∈ {*k,* ... , *t*}, *z_{k,t}*[*i*] ≠ *zₐ*[*i - k +* 1]}, where *zₐ* ∈ *Q*^{*t-k+*1} is the *Q*-vector represented by *a.*

Let *A* be an algorithm representing *vect_{Q}*(*M*) as a string over Σ with a given admissible weighted error. Algorithm *A* may be a greedy algorithm which chooses a suitable symbol in Σ with the maximum length at each iteration. An example of algorithm *A* may be the following:

| | |
|---|---|
| Input: *z = vect_{Q}*(*M*) and *ρ* ≥ 0 (admissible error rate, may be zero) | |
| Output: String *x* over Σ representing z. | |
| *k*: *=* 1, *e*: = 0, let *x* be an empty string. | |
| **while** *k* is not greater than the length of *z* **do** | |
| | Choose *z_{k,t}* with maximum *t - k* such that *z_{k,t}* is represented by a symbol *a* ∈ Σ with the weighted error not greater than the total weight of z times *ρ* minus *e.* |
| | Increase *e* by the weighted error with which *a* represents *z_{k,t}*. Write *a* to the end of *x*. |
| | *k*: *= t +* 1 |
| **end while** | |
| Return x. | |

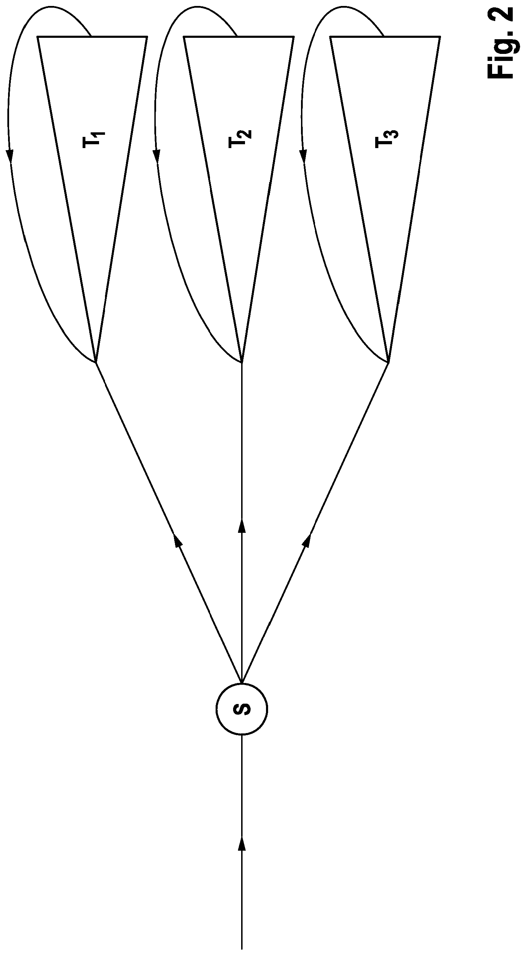

The sensor data may be encoded by an encoder using algorithm *A* to construct a string *x* representing input matrix *M.* Mathematically speaking, the encoder may be represented as a finite-state machine represented in the form of a directed graph, which graph is also shown in **Fig. 2** and which may comprise the following components:
- A collection of decision trees *T*₁*, ... , Tₖ,* one for each index *i* ∈ [*m*], each tree being described by a decision pattern *DPᵢ.*
- A node *s* which may be connected with each *Tᵢ* by an arc (*s, r*(*Tᵢ*))*.*
- A mapping *φ*: {0,1}*^{c}* → [*m*] associated with s.
- For each *Tᵢ*: Arcs connecting the leaves of *Tᵢ* with its root *r*(*Tᵢ*)*.*
- For each *Tᵢ*: Each node *v* ≠ *r*(*Tᵢ*) may be labeled by *a* ∈ Σ. This label may be denoted by *a*(*v*)*.*
- For each *Tᵢ*: For each node *v* there may be an associated family of *decision sets S*(*v, a*) ⊂ [-1,1]², *a* ∈ Σ:
   - If *v* is not the root and w is its parent node, then ∪_{*a*∈Σ} *S*(*v, a*) *= S*(*w, a*(*v*))*.* ${∪}_{a ∈ Σ} S \left(r\left({T}_{i}\right),a\right) = {\left[-1,1\right]}^{2} .$
- A leaf of *Tᵢ* may be a node *l* such that a further application of the respective decision pattern would lead to a child *v* of *l* such that the smallest side of *S*(*v, a*) is smaller than Δ for some *a* ∈ Σ, where Δ may be a hyper-parameter, for example chosen by the user or predetermined.

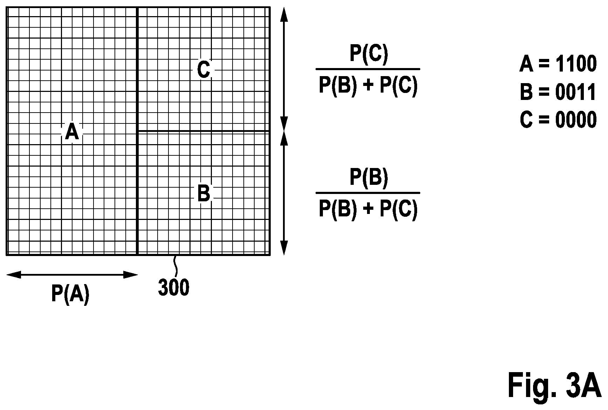

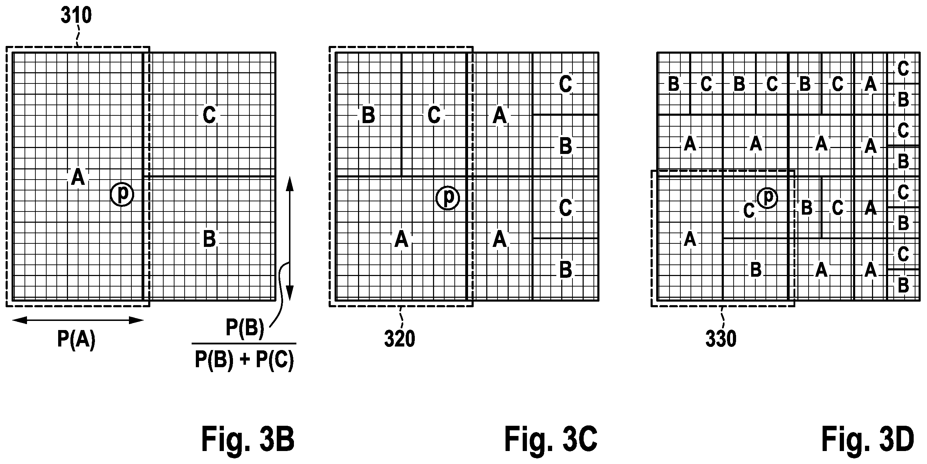

**Fig. 3A** illustrates how a static decision pattern may map coordinates in a 2D coordinate system to symbols of an auxiliary alphabet. The static decision pattern may be a rule or an algorithm prescribing how to partition an area into a set of areas with each area from the set representing a different symbol from the auxiliary alphabet. In this static decision pattern, the following frequencies of occurrences are assumed: *P*(*A*) = 1/2, *P*(*B*) = 1/4, and *P*(*C*) = 1/4 of symbols *A, B,* and *C* of Σ. The size of each area may be selected proportionally to the frequency of occurrence.

**Figs. 3B-3D** illustrate how a point in the 2D coordinate system may be converted into a series of symbols and vice versa on the basis of a recursive partitioning of areas. In other words, the decision pattern of Fig. 3A may be used for branching in a decision tree. It can be seen that the areas associated with symbols contain a smaller number of lattice points at the next level. Point *p* may encode string *AAC.* Point *p* may be represented as a complex number *z*(*p*) and sent to the receiver.

Below a dynamic decision pattern is described in which the decision pattern takes decisions using a probability distribution *Pᵥ* associated with a given node. The following may represent a recursive application of the decision pattern *DPᵢ* to a given node:

| | |
|---|---|
| Input: Node *v*. | |
| Output: *S*(*v, a*), ∀*a* ∈ Σ. | |
| Let R = [-1,1]² if *v = r*(*Tᵢ*)*.* Otherwise, let *R = S*(*w, a*(*v*)) where *w* is the parent node of *v*. | |
| Σ': = Ø, 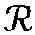 : = {*R*}, Σ*_{R}*: = Σ. | |
| **while** There exists *R'* ∈ 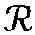 with \|Σ*_{R'}*\| > 1 **do** | |
| | Put *Pᵥ*(*a*), *a* ∈ Σ*_{R'}*, in the decreasing order: *p*₁ ≥ *p*₂ ≥ ··· ≥ *pₜ.* |
| | $ξ : = \left({p}_{1}+⋯+{p}_{\left⌊t/2\right⌋}\right) / \left({p}_{1}+⋯+{p}_{t}\right)$ |
| | Choose a side of R' of the maximum length. |
| | Divide R' by the line segment perpendicular to the mentioned side such that R' is decomposed into two rectangles *R*₁ and *R*₂ with areas *ξ* and 1 - *ξ*, respectively. |
| | Let Σ_{*R*1} be the part of Σ*_{R'}* corresponding to ${p}_{1} , … , {p}_{\left⌊t/2\right⌋} . {Σ}_{{R}_{2}} : = {Σ}_{R ′} \ {Σ}_{{R}_{1}}$. |
| | Replace *R*' by *R*₁ and *R*₂ in collection 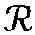 . |
| **end while** | |
| **for** R' E 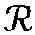 **do** | |
| | Set *S*(*v*, *a*): *= R',* where *a* is such that Σ*_{R'}* = {*a*}. |
| **end for** | |
| Return the sets S(*v*, *a*). | |

The above procedure may decompose *R* into rectangles, being an example of the aforementioned areas, associated with the symbols of Σ. The areas of the rectangles relatively to the area of *R* may in some examples be exactly proportional to the respective probabilities *Pᵥ*(*a*), *a* ∈ Σ. The dynamic choice of *Pᵥ* may allow one to take into account complex dependencies of probabilities of observing a given symbol of the previously observed combinations of symbols in the same string representing *M*. Since *Pᵥ* depends on *v, Pᵥ* may also depend on the class *i* associated with *Tᵢ* containing *v*.

The encoder may encode *M* as a sequence of complex numbers and represent them as a binary string in a given complex base admitting a binary representation:

| | | |
|---|---|---|
| Input; *b* E {0,1}*^{c}* and complex matrix *M*. | | |
| Output: *y* being a vector of complex numbers encoding *M* and its binary representation in a given complex base. | | |
| Use algorithm *A* to represent *M* as a string *x* over *Σ*. | | |
| Compute *i* = *φ*(*b*)*.* | | |
| Let *v = r*(*Tᵢ*)*.* This is the current node. | | |
| *k: =* 1. This is the index of the current symbol in x. | | |
| **while** *k* is less than the length of *x* **do** | | |
| | w: = *v* | |
| | Let *v* be the child node of w with *a*(*v*) = *xₖ.* | |
| | **if** *v* is a leaf of *Tᵢ* **then** | |
| | | Set *v*: = *r*(*Tᵢ*). (Go back to the root of *Tᵢ*.) |
| | | Choose *p* in the interior of *S*(*v, xₖ*) having the minimum bit length of its binary representation in a given complex base (e.g., *i* - 1 (see for example Walter Penney. 1965. A "Binary" System for Complex Numbers. J. ACM 12, 2 (April 1965), 247-248. https://doi.org/10.1145/321264.321274) and write its complex representation to the end of *y*. |
| | **end if** | |
| | *k: = k + 1* | |
| **end while** | | |
| **if** v is not a leaf of *Tᵢ* **then** | | |
| | Choose *p* in the interior of *S*(*v, xₖ*) having the minimum bit length of its binary representation in a given complex base and write its complex representation to the end of *y*. | |
| **end if** | | |
| Return the complex vector *y*, the binary representations of its components and their binary lengths. | | |

The decoder may reconstruct the sensor data which may be received in encoded form, namely in form of a sequence of complex numbers or their binary representations (with known binary lengths of components and the complex base in which they have been encoded) as follows:

| | | |
|---|---|---|
| Input: *b* E {0,1}*^{c}*, *n*, and *y* given as a complex vector or its binary representation. | | |
| Output: The matrix *M* encoded by*y*. | | |
| Choose *i* = *φ*(*b*)*.* | | |
| Let *v* = *r*(*Tᵢ*). This is the current node. | | |
| *k: =* 1 (This is the index of the current complex number in *y.)* | | |
| *r*: = 0 (This is the counter of the number of symbols of Q discovered by the current iteration.) | | |
| Let *x* be an empty string. | | |
| **while** *a*(*v*) ≠ *"ED"* and *r < n* **do** | | |
| | **if** *v* ≠ *r*(*Tᵢ*) **then** | |
| | | Write *a*(*v*) to the end of *x*. |
| | | *r*: = *r* + *size_{Q}*(*a*(*v*)) where *size_{Q}*(*a*(*v*)) is the number of symbols of Q represented by *a*(*v*)*.* |
| | **end if** | |
| | *w*: = *v* | |
| | Set *v* to the child node of w, labeled with *a*(*v*), such that *yₖ* ∈ *S*(*v, a*(*v*))*.* | |
| | **if** *v* is a leaf of *Tᵢ* **then** | |
| | | Set *v*: = *r*(*Tᵢ*)*.* (Go back to the root of *Tᵢ*.) |
| | | *k: = k +* 1 |
| | **end if** | |
| **end while** | | |
| If "ED" is contained in Σ, write "*ED*" to the end of *x.* | | |
| To obtain *vect_{Q}*(*M*), first replace the components of *x* by the respective series of symbols of Q. | | |
| Then construct *vect_{Q}*(*M*) by partitioning *vect_{Q}*(*M*) in series of $\left⌈{log}_{2}u\right⌉$ symbols of Q. After that, represent each entry of M as the respective expansion. | | |
| Return M. | | |

A coding system *S_{θ}* may be configured by *θ* describing the coding scheme: *θ* consists of the lattice *L*, the decision patterns associated with the trees and their nodes, the mapping *φ* associated with node s, and the auxiliary alphabet Σ. Let Σ₀ be an initial auxiliary alphabet (it contains Q and may, e.g., include series *q* ··· q, for each *q* ∈ *Q*, whose lengths are powers of 2, up to a given length not greater than the dimension of *vect*(*M*)*).* Let 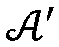 consist of all alphabets each of which can be obtained from Σ₀ by modifying *Q*-vectors represented by symbols of Σ₀. For instance, if a component of a *Q*-vector of the form *q* ··· *q* is to be modified to *q', q* is to be changed to *q*' at the respective position of that *Q*-vector. Let 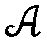 be the family of all alphabets containing *Q* as a subset and being subsets of alphabets in 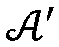 *.* The problem of finding an optimal alphabet can be formulated as the following optimization problem: ${min}_{Σ ∈ A} \frac{1}{\left|D\right|} {\sum }_{M ∈ D} f ∘ {S}_{θ \left(Σ\right)} \left(M\right) ,$ where *D* is a training set and *f* is the total binary length of *M* ∈ *D* in a given complex base when using *S_{θ}*. Here, the notation *θ*(Σ) means a configuration which is chosen based on alphabet Σ with all other parameters such as the Δ and decision patterns being fixed.

To start with the straightforward binary representation of *vect_{Q}*(*M*), one may choose alphabet Σ₀ = *Q* as the initial solution and a decision pattern determined by equal probabilities for all symbols. The Δ can be chosen as Δ = *2*/*u. Remark:* By choosing a sufficiently small Δ one may encode *M* as a single complex number. Moreover, if the sender and receiver are analog devices exchanging signals that can be interpreted as sequences of complex numbers, the vector *y* may be transmitted directly. In this case Δ may be selected to correspond to the accuracy with which the devices are able to measure, transmit, and receive such complex numbers.

For solving the above optimization problem, taking into account that alphabets of 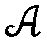 can be interpreted as binary vectors, any suitable black-box optimization method for binary optimization may be used.

It is noted that function *φ* can be a binary decision diagram whose input would be *b* and the output be a unit vector whose nonzero component would correspond to *i.*

Initially, probability distributions *Pᵥ* can all be equal (e.g., to a probability distribution representing empirical probabilities of symbols of the respective alphabet Σ), in which case we are talking about a static decision pattern for each *i*. By means of black-box optimization and machine-learning techniques, more suitable *Pᵥ*'s may be learned as functions depending on *i* and sequences of symbols observed when going from the root of *Tᵢ* to *v.*

Note that one may also optimize with respect to the complex base in which binary representations of complex numbers are computed in the output of the encoder.

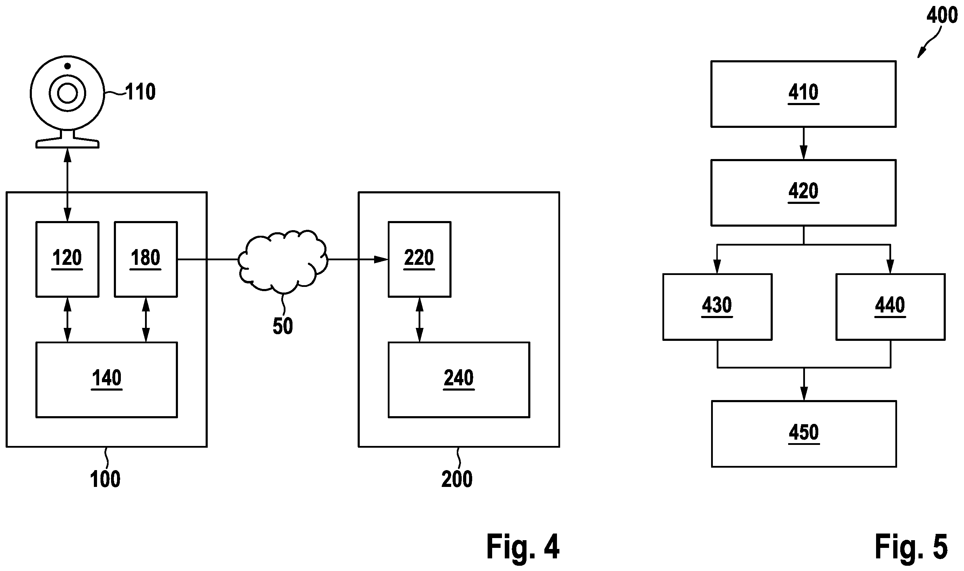

**Fig. 4** shows a data exchange between a sender device 100 and a receiver device 200. The sender device 100 may be configured to encode sensor data for transmission to the receiver device 200, or to any other receiver. To obtain access to the sensor data, the sender device 100 may comprise a sensor interface 120 to a sensor 110. By way of example, the sensor 110 is shown in Fig. 4 in the form of an external camera 110. Alternatively, the sensor 110 may be an internal, e.g., built-in, component of the sender device 100, such as a built-in camera. Moreover, alternatively or in addition to a camera, the sensor 110 may comprise any other type of sensor, such as an ultrasound sensor, lidar sensor, radar sensor, microphone, etc. The sensor interface 120 may be a type of sensor interface which corresponds to the type of sensor 110. For example, for the example of the sensor being a camera, the sensor interface may be a camera interface, etc. In general, the sensor interface 120 may be a bus-type of interface, such as an USB interface, or a serial interface, such as a CSI interface, or a network interface, such as a wireless network interface based on Wi-Fi, Bluetooth, Zigbee, Matter, etc., or an application specific interface such as a MIPI interface for automotive applications, etc.

The sender device 100 may further comprise a processor subsystem 140 which may be configured to provide the functionality as described in this specification with respect to the encoding of the sensor data for transmission to a receiver. For that purpose, although not shown in Fig. 4, the sender device 100 may comprise a memory comprising corresponding computer-readable instructions for the processor subsystem.

The sender device 100 may further comprise a communication interface 180 to the receiver device 200. Using the communication interface 180, the sender device 100 may provide the encoded sensor data and the object data as described elsewhere in this specification to the receiver device 200, for example via a communication channel 50. In one example, the communication interface 180 may be a network interface, such as a wired network interface based on Ethernet or optical communication or a wireless network interface based on Wi-Fi_{___}33, Bluetooth, Zigbee, Matter, etc. Another example is that the communication interface 180 may be a bus-type of interface or a serial interface or an application specific interface, for example of the types as described above for the sensor interface 120.

In some examples, the sender device 100 may be a sensor device in that the sender device may comprise the sensor and limited processing means enabling the sensor to generate and send the encoded sensor data to the receiver device 200. In a specific example, the sender device 100 may be a node in a distributed sensor network. In another specific example, the sender device 100 may be an automotive sensor device and the object data may be a collective perception message (CPM). Another specific example is that the sender device 100 may be an Internet-of- Things (IoT) device.

Fig. 4 further shows a receiver device 200 which is shown to comprise a communication interface 220 of a type as described with reference to the communication interface 180 of the sender device 100. The receiver device 200 may further comprise a processor subsystem 240 which may be configured to provide the functionality as described in this specification with respect to the decoding of the sensor data received from the sender device 100. For that purpose, although not shown in Fig. 4, the receiver device 200 may comprise a memory comprising computer-readable instructions for the processor subsystem 240. The receiver device 200 may for example be a central processing node of a distributed sensor network. In a specific example, the receiver device 200 may be an automotive processing unit. Another specific example is that the receiver device 200 may be a server or host computer. In some examples, the receiver device 200 may be a same type of device as the sender device 100, e.g., in applications in which the processing of the sensor data is distributed amongst devices.

With further reference to the processor subsystems 140, 240 of the sender device and the receiver device, each of these may be embodied by a single CPU, such as a x86 or ARM-based CPU, but also by a combination of such CPUs and/or other types of processing units, such as GPUs.

In general, each entity described in this specification may be embodied as, or in, a device or apparatus. The device or apparatus may comprise one or more (micro)processors which execute appropriate software. The processor(s) of a respective entity may be embodied by one or more of these (micro)processors. Software implementing the functionality of a respective entity may have been downloaded and/or stored in a corresponding memory or memories, e.g., in volatile memory such as RAM or in non-volatile memory such as Flash. Alternatively, the processor(s) of a respective entity may be implemented in the device or apparatus in the form of programmable logic, e.g., as a Field-Programmable Gate Array (FPGA). Any input and/or output interfaces may be implemented by respective interfaces of the device or apparatus. Each functional unit of a respective entity may be implemented in the form of a circuit or circuitry. A respective entity may also be implemented in a distributed manner, e.g., involving different devices or apparatus.

**Fig. 5** shows a method 400 of encoding sensor data for transmission to a receiver. The method 400 may correspond to an operation of the sender device as described elsewhere in this specification. However, this is not a limitation, in that the method 400 may also be performed using another system, apparatus or device.

The method 400 may comprise, in a step titled "OBTAINING SENSOR DATA ACQUIRED BY SENSOR", obtaining 410 sensor data acquired by a sensor. The method 400 may further comprise, in a step titled "APPLYING OBJECT DETECTION TECHNIQUE TO SENSOR DATA", applying 420 an object detection technique to the sensor data to detect an object in the sensor data and to determine one or more attributes of the object. The method 400 may further comprise, in a step titled "ENCODING SENSOR DATA USING DATA COMPRESSION TECHNIQUE", encoding 430 the sensor data to obtain encoded sensor data, wherein the encoding comprises applying a data compression technique to the sensor data, wherein the data compression technique is configurable by one or more compression parameters, wherein applying the data compression technique to the sensor data comprises selecting at least one of the one or more compression parameters based on the one or more attributes of the object. The method 400 may further comprise, in a step titled "GENERATING OBJECT DATA", generating 440 object data indicative of the one or more attributes of the object. The method 400 may further comprise, in a step titled "SENDING ENCODED SENSOR DATA AND OBJECT DATA TO RECEIVER", sending 450 the encoded sensor data and the object data to the receiver to enable the receiver to select one or more decompression parameters of a data decompression technique based on the one or more attributes of the object.

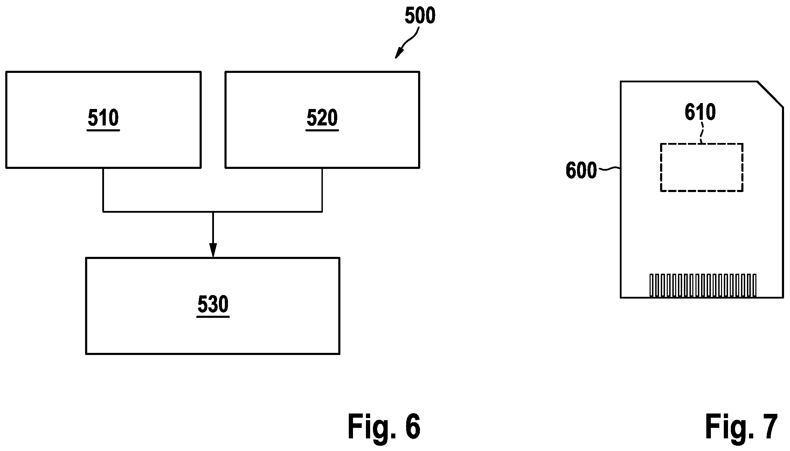

**Fig. 6** shows a method 500 of decoding sensor data received from a sender. The method 500 may correspond to an operation of the receiver device as described elsewhere in this specification. However, this is not a limitation, in that the method 500 may also be performed using another system, apparatus or device.

The method 500 may comprise, in a step titled "RECEIVING ENCODED SENSOR DATA FROM SENDER", receiving 510 encoded sensor data from the sender. The method 500 may further comprise, in a step titled "RECEIVING OBJECT DATA", receiving 520 object data from the sender, wherein the object data is indicative of one or more attributes of an object which is detectable in the sensor data. The method 500 may further comprise, in a step titled "DECODING ENCODED SENSOR DATA BASED ON OBJECT DATA", decoding 530 the encoded sensor data to obtain decoded sensor data, wherein the decoding comprises applying a data decompression technique to the encoded sensor data, wherein the data decompression technique is configurable by one or more decompression parameters, wherein applying the data decompression technique to the encoded sensor data comprises selecting at least one of the one or more decompression parameters based on the one or more attributes of the object.

It will be appreciated that, in general, the steps of the method 400 of Fig. 5 and those of the method 500 of Fig. 6 may be performed in any suitable order, e.g., consecutively, simultaneously, or a combination thereof, subject to, where applicable, a particular order being necessitated, e.g., by input/output relations.

The method(s) may be implemented on a computer as a computer implemented method, as dedicated hardware, or as a combination of both. As also illustrated in **Fig. 7**, instructions for the computer, e.g., executable code, may be stored on a computer-readable medium 600, e.g., in the form of a series 610 of machine-readable physical marks and/or as a series of elements having different electrical, e.g., magnetic, or optical properties or values. The computer-readable medium 600 may be transitory or non-transitory. Examples of computer-readable mediums include memory devices, optical storage devices, integrated circuits, etc. Fig. 7 shows a memory card 600.

Examples, embodiments or optional features, whether indicated as nonlimiting or not, are not to be understood as limiting the invention as claimed.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or stages other than those stated in a claim. The article "a" or "an" preceding an element does not exclude the presence of a plurality of such elements. Expressions such as "at least one of" when preceding a list or group of elements represent a selection of all or of any subset of elements from the list or group. For example, the expression, "at least one of A, B, and C" should be understood as including only A, only B, only C, both A and B, both A and C, both B and C, or all of A, B, and C. The invention may be implemented by means of hardware comprising several distinct elements, and by means of a suitably programmed computer. In the device claim enumerating several means, several of these means may be embodied by one and the same item of hardware. The mere fact that certain measures are recited in mutually different dependent claims does not indicate that a combination of these measures cannot be used to advantage.

## Claims

1. A computer-implemented method (400) of encoding sensor data for transmission to a receiver, comprising:
- obtaining (410) sensor data acquired by a sensor;
- applying (420) an object detection technique to the sensor data to detect an object in the sensor data and to determine one or more attributes of the object;
- encoding (430) the sensor data to obtain encoded sensor data, wherein the encoding comprises applying a data compression technique to the sensor data, wherein the data compression technique is configurable by one or more compression parameters, wherein applying the data compression technique to the sensor data comprises selecting at least one of the one or more compression parameters based on the one or more attributes of the object, wherein applying the data compression technique to the sensor data comprises:
- processing the sensor data to consecutively identify data patterns in the sensor data and convert each respective data pattern into a symbol selected from an auxiliary alphabet, thereby obtaining a string of symbols representing the sensor data;
- encoding the string of symbols to obtain a binary representation of the string of symbols, wherein the encoding uses a decision pattern for decision-making in the encoding, wherein selecting the at least one of the one or more compression parameters comprises selecting the decision pattern based on the one or more attributes of the object, for example by selecting a different decision pattern for different values of an attribute of the object;
- generating (440) object data indicative of the one or more attributes of the object;
- sending (450) the encoded sensor data and the object data to the receiver to enable the receiver to select one or more decompression parameters of a data decompression technique based on the one or more attributes of the object.

2. The method (400) according to claim 1, wherein encoding the string of symbols comprises using the decision pattern recursively for respective symbols.

3. The method (400) according to claim 2, wherein encoding the string of symbols comprises generating a complex number to represent at least a substring of the string of symbols, wherein the decision pattern is representable as a set of areas (300) in a 2D coordinate system, each area from the set of areas representing a different symbol from the auxiliary alphabet, wherein the complex number is selected by recursively:
- selecting an area (310) from the set of areas corresponding to a current symbol of the substring;
- partitioning (320, 330) said selected area to obtain a set of subareas corresponding to an geometric arrangement of areas in the set of areas; and
- selecting a subarea from the set of subareas corresponding to a next symbol of the substring;
wherein the complex number to represent the substring is selected based on a coordinate in the 2D coordinate system of a last subarea selected for a last symbol of the substring, for example based on a centroid of the last subarea; and
- optionally, generating a binary representation of the complex number for transmission to the receiver.

4. The method (400) according to claim 3, further comprising:
- determining a frequency of a respective data pattern in the sensor data to obtain a frequency of a corresponding symbol from the auxiliary alphabet; and
- determining a relative size of each area in the set of areas based on the frequency, for example proportionally to the frequency.

5. The method (400) according to claim 4, further comprising initially selecting a relative size of each area in the set of areas to be equal and adjusting the relative size during the encoding based on observed frequencies of respective data patterns.

6. The method (400) according to any one of claims 3 to 5, further comprising selecting the auxiliary alphabet using a machine learning technique, wherein the machine learning technique is trained to select respective symbols of the auxiliary alphabet so that a binary representation of the string of symbols has a minimum binary length in a complex base in which the binary representation of the complex number is generated.

7. The method (400) according to any one of claims 3 to 6, further comprising selecting a complex base in which a binary representation of the complex number is generated using a machine learning technique, wherein the machine learning technique is trained to select the complex base so that the binary representation of the complex number has a minimum binary length in the complex base.

8. The method (400) according to any one of claims 1 to 7, wherein the object detection technique is configured to detect and classify the object in the sensor data to obtain an object classification as an attribute of the object.

9. The method (400) according to any one of claims 1 to 8, wherein the sensor data comprises or is representable as a series or an array of complex numbers, for example in form of a magnitude and a phase.

10. The method (400) according to any one of claims 1 to 9, wherein the sensor data comprises or is an array of sensor data elements, for example in form of an image.

11. A computer-implemented method (500) of decoding sensor data received from a sender, comprising:
- receiving (510) encoded sensor data from the sender;
- receiving (520) object data from the sender, wherein the object data is indicative of one or more attributes of an object which is detectable in the sensor data; and
- decoding (530) the encoded sensor data to obtain decoded sensor data, wherein the decoding comprises applying a data decompression technique to the encoded sensor data, wherein the data decompression technique is configurable by one or more decompression parameters, wherein applying the data decompression technique to the encoded sensor data comprises selecting at least one of the one or more decompression parameters based on the one or more attributes of the object, wherein the encoded sensor data comprises a binary representation of a string of symbols representing the sensor data, wherein the symbols in the string of symbols are selected from an auxiliary alphabet to represent different data patterns in the sensor data, wherein decoding the encoded sensor data comprises decoding the binary representation of the string of symbols to obtain the string of symbols, wherein a decision pattern is used for decision-making in the decoding, wherein selecting the at least one of the one or more decompression parameters comprises selecting the decision pattern based on the one or more attributes of the object, for example by selecting a different decision pattern for different values of an attribute of the object.

12. A transitory or non-transitory computer-readable medium (600) comprising data (610) representing instructions which, when executed by a processor system, cause the processor system to perform the computer-implemented method according to any one of claims 1 to 11.

13. A sender device (100) comprising a processor subsystem (140), a sensor interface (120) to a sensor (110), and a communication interface (180) to a receiver device, wherein the sender device is configured to perform the method according to any one of claims 1 to 10.

14. A receiver device (200) comprising a processor subsystem (240) and a communication interface (220) to a sender device, wherein the receiver device is configured to perform the method according to claim 11.

15. A distributed sensor network comprising a sender device (100) according to claim 13 and a receiver device (200) according to claim 14, wherein the sender device is for example a sensor device and the receiver device is for example a sensor data processing device.

## Patentansprüche

1. Computerimplementiertes Verfahren (400) zum Codieren von Sensordaten zur Übertragung an einen Empfänger, das Folgendes umfasst:
- Erhalten (410) von Sensordaten, die von einem Sensor erfasst werden;
- Anwenden (420) einer Objektdetektionstechnik auf die Sensordaten, um ein Objekt in den Sensordaten zu detektieren und ein oder mehrere Attribute des Objekts zu bestimmen;
- Codieren (430) der Sensordaten, um codierte Sensordaten zu erhalten, wobei das Codieren das Anwenden einer Datenkomprimierungstechnik auf die Sensordaten umfasst, wobei die Datenkomprimierungstechnik durch einen oder mehrere Komprimierungsparameter konfigurierbar ist, wobei das Anwenden der Datenkomprimierungstechnik auf die Sensordaten das Auswählen mindestens eines des einen oder der mehreren Komprimierungsparameter basierend auf dem einen oder den mehreren Attributen des Objekts umfasst, wobei das Anwenden der Datenkomprimierungstechnik auf die Sensordaten Folgendes umfasst:
- Verarbeiten der Sensordaten, um nacheinander Datenmuster in den Sensordaten zu identifizieren und jedes jeweilige Datenmuster in ein Symbol umzuwandeln, das aus einem Hilfsalphabet ausgewählt ist, wodurch eine Folge von Symbolen erhalten wird, die die Sensordaten darstellen;
- Codieren der Folge von Symbolen, um eine binäre Darstellung der Folge von Symbolen zu erhalten, wobei die Codierung ein Entscheidungsmuster zur Entscheidungsfindung bei der Codierung verwendet, wobei das Auswählen des mindestens einen des einen oder der mehreren Kompressionsparameter das Auswählen des Entscheidungsmusters basierend auf dem einen oder den mehreren Attributen des Objekts umfasst, zum Beispiel durch Auswählen eines anderen Entscheidungsmusters für verschiedene Werte eines Attributs des Objekts;
- Erzeugen (440) von Objektdaten, die das eine oder die mehreren Attribute des Objekts angeben;
- Senden (450) der codierten Sensordaten und der Objektdaten an den Empfänger, um es dem Empfänger zu ermöglichen, einen oder mehrere Dekomprimierungsparameter einer Datendekomprimierungstechnik basierend auf dem einen oder den mehreren Attributen des Objekts auszuwählen.

2. Verfahren (400) nach Anspruch 1, wobei das Codieren der Folge von Symbolen das rekursive Verwenden des Entscheidungsmusters für jeweilige Symbole umfasst.

3. Verfahren (400) nach Anspruch 2, wobei das Codieren der Folge von Symbolen das Erzeugen einer komplexen Zahl umfasst, um mindestens eine Teilsymbolfolge der Folge von Symbolen darzustellen, wobei das Entscheidungsmuster als ein Satz von Bereichen (300) in einem 2D-Koordinatensystem darstellbar ist, wobei jeder Bereich aus dem Satz von Bereichen ein anderes Symbol von dem Hilfsalphabet darstellt, wobei die komplexe Zahl ausgewählt wird durch rekursives:
- Auswählen eines Bereichs (310) aus dem Satz von Bereichen, der einem aktuellen Symbol der Teilsymbolfolge entspricht;
- Partitionieren (320, 330) des ausgewählten Bereichs, um einen Satz von Teilbereichen zu erhalten, der einer geometrischen Anordnung von Bereichen in dem Satz von Bereichen entspricht; und
- Auswählen eines Teilbereichs aus dem Satz von Teilbereichen, der einem nächsten Symbol der Teilsymbolfolge entspricht;
wobei die komplexe Zahl zum Darstellen der Teilsymbolfolge basierend auf einer Koordinate im 2D-Koordinatensystem eines letzten Teilbereichs ausgewählt wird, der für ein letztes Symbol der Teilsymbolfolge ausgewählt wurde, zum Beispiel basierend auf einem Schwerpunkt des letzten Teilbereichs; und
- optional Erzeugen einer binären Darstellung der komplexen Zahl zur Übertragung an den Empfänger.

4. Verfahren (400) gemäß Anspruch 3, das ferner Folgendes umfasst:
- Bestimmen einer Häufigkeit eines jeweiligen Datenmusters in den Sensordaten, um eine Häufigkeit eines entsprechenden Symbols aus dem Hilfsalphabet zu erhalten; und
- Bestimmen einer relativen Größe jedes Bereichs in dem Satz von Bereichen basierend auf der Häufigkeit, zum Beispiel proportional zur Häufigkeit.

5. Verfahren (400) nach Anspruch 4, ferner umfassend das anfängliche Auswählen einer relativen Größe jedes Bereichs in dem Satz von Bereichen als gleich und Anpassen der relativen Größe während des Codierens basierend auf beobachteten Häufigkeiten jeweiliger Datenmuster.

6. Verfahren (400) nach einem der Ansprüche 3 bis 5, ferner umfassend das Auswählen des Hilfsalphabets unter Verwendung einer Maschinenlerntechnik, wobei die Maschinenlerntechnik trainiert ist, jeweilige Symbole des Hilfsalphabets auszuwählen, so dass eine binäre Darstellung der Folge von Symbolen eine minimale binäre Länge in einer komplexen Basis aufweist, in der die binäre Darstellung der komplexen Zahl erzeugt wird.

7. Verfahren (400) nach einem der Ansprüche 3 bis 6, ferner umfassend das Auswählen einer komplexen Basis, in der eine binäre Darstellung der komplexen Zahl unter Verwendung einer Maschinenlerntechnik erzeugt wird, wobei die Maschinenlerntechnik trainiert ist, die komplexe Basis so auszuwählen, dass die binäre Darstellung der komplexen Zahl eine minimale binäre Länge in der komplexen Basis aufweist.

8. Verfahren (400) nach einem der Ansprüche 1 bis 7, wobei die Objektdetektionstechnik dazu ausgelegt ist, das Objekt in den Sensordaten zu detektieren und zu klassifizieren, um eine Objektklassifizierung als ein Attribut des Objekts zu erhalten.

9. Verfahren (400) nach einem der Ansprüche 1 bis 8, wobei die Sensordaten eine Reihe oder ein Array komplexer Zahlen, zum Beispiel in Form einer Größe und einer Phase, umfassen oder als solche darstellbar sind.

10. Verfahren (400) nach einem der Ansprüche 1 bis 9, wobei die Sensordaten ein Array von Sensordatenelementen umfassen oder sind, zum Beispiel in Form eines Bildes.

11. Computerimplementiertes Verfahren (500) zum Decodieren von Sensordaten, die von einem Sender empfangen werden, umfassend:
- Empfangen (510) codierter Sensordaten vom Sender;
- Empfangen (520) von Objektdaten vom Sender, wobei die Objektdaten ein oder mehrere Attribute eines Objekts angeben, das in den Sensordaten detektierbar ist; und
- Decodieren (530) der codierten Sensordaten, um decodierte Sensordaten zu erhalten, wobei das Decodieren das Anwenden einer Datendekomprimierungstechnik auf die codierten Sensordaten umfasst, wobei die Datendekomprimierungstechnik durch einen oder mehrere Dekomprimierungsparameter konfigurierbar ist, wobei das Anwenden der Datendekomprimierungstechnik auf die codierten Sensordaten das Auswählen mindestens eines des einen oder der mehreren Dekomprimierungsparameter basierend auf dem einen oder den mehreren Attributen des Objekts umfasst, wobei die codierten Sensordaten eine binäre Darstellung einer Folge von Symbolen umfassen, die die Sensordaten darstellen, wobei die Symbole in der Folge von Symbolen aus einem Hilfsalphabet ausgewählt werden, um unterschiedliche Datenmuster in den Sensordaten darstellen zu können, wobei das Decodieren der codierten Sensordaten das Decodieren der binären Darstellung der Folge von Symbolen umfasst, um die Folge von Symbolen zu erhalten, wobei ein Entscheidungsmuster zur Entscheidungsfindung beim Decodieren verwendet wird, wobei das Auswählen des mindestens einen des einen oder der mehreren Dekomprimierungsparameter das Auswählen des Entscheidungsmusters basierend auf dem einen oder den mehreren Attributen des Objekts umfasst, zum Beispiel durch Auswählen eines anderen Entscheidungsmusters für verschiedene Werte eines Attributs des Objekts.

12. Transitorisches oder nicht-transitorisches computerlesbares Medium (600), das Daten (610) umfasst, die Anweisungen repräsentieren, die bei Ausführung durch ein Prozessorsystem das Prozessorsystem dazu veranlassen, das computer-implementierte Verfahren nach einem der Ansprüche 1 bis 11 durchzuführen.

13. Sendervorrichtung (100), die ein Prozessorsubsystem (140), eine Sensorschnittstelle (120) zu einem Sensor (110) und eine Kommunikationsschnittstelle (180) zu einer Empfängervorrichtung umfasst, wobei die Sendervorrichtung dazu ausgelegt ist, das Verfahren nach einem der Ansprüche 1 bis 10 durchzuführen.

14. Empfängervorrichtung (200), die ein Prozessorsubsystem (240) und eine Kommunikationsschnittstelle (220) zu einer Sendervorrichtung umfasst, wobei die Empfängervorrichtung dazu ausgelegt ist, das Verfahren nach Anspruch 11 durchzuführen.

15. Verteiltes Sensornetzwerk, das eine Sendervorrichtung (100) nach Anspruch 13 und eine Empfängervorrichtung (200) nach Anspruch 14 umfasst, wobei die Sendervorrichtung zum Beispiel eine Sensorvorrichtung ist und die Empfängervorrichtung zum Beispiel eine Sensordatenverarbeitungsvorrichtung ist.

## Revendications

1. Procédé mis en œuvre par ordinateur (400) d'encodage de données de capteur pour la transmission à un récepteur, comprenant :
- l'obtention (410) de données de capteur acquises par un capteur ;
- l'application (420) d'une technique de détection d'objet aux données de capteur pour détecter un objet dans les données de capteur et pour déterminer un ou plusieurs attributs de l'objet ;
- l'encodage (430) des données de capteur pour obtenir des données de capteur encodées, dans lequel l'encodage comprend l'application d'une technique de compression de données aux données de capteur, dans lequel la technique de compression de données est configurable par un ou plusieurs paramètres de compression, dans lequel l'application de la technique de compression de données aux données de capteur comprend la sélection d'au moins un de l'un ou des plusieurs paramètres de compression sur la base de l'un ou des plusieurs attributs de l'objet, dans lequel l'application de la technique de compression de données aux données de capteur comprend :
- le traitement des données de capteur pour consécutivement identifier des modèles de données dans les données de capteur et convertir chaque modèle de données respectif en un symbole sélectionné parmi un alphabet auxiliaire, obtenant ainsi une chaîne de symboles représentant les données de capteur ;
- l'encodage de la chaîne de symboles pour obtenir une représentation binaire de la chaîne de symboles, dans lequel l'encodage utilise un modèle de décision pour la prise de décision dans l'encodage, dans lequel la sélection de l'au moins un de l'un ou des plusieurs paramètres de compression comprend la sélection du modèle de décision sur la base de l'un ou des plusieurs attributs de l'objet, par exemple en sélectionnant un modèle de décision différent pour des valeurs différentes d'un attribut de l'objet ;
- la génération (440) de données d'objet indicatives de l'un ou des plusieurs attributs de l'objet ;
- l'envoi (450) des données de capteur encodées et des données d'objet au récepteur pour permettre au récepteur de sélectionner un ou plusieurs paramètres de décompression d'une technique de décompression de données sur la base de l'un ou des plusieurs attributs de l'objet.

2. Procédé (400) selon la revendication 1, dans lequel l'encodage de la chaîne de symboles comprend l'utilisation récursive du modèle de décision pour des symboles respectifs.

3. Procédé (400) selon la revendication 2, dans lequel l'encodage de la chaîne de symboles comprend la génération d'un nombre complexe pour représenter au moins une sous-chaîne de la chaîne de symboles, dans lequel le modèle de décision est représentable sous forme d'ensemble de zones (300) dans un système de coordonnées 2D, chaque zone parmi l'ensemble de zones représentant un symbole différent parmi l'alphabet auxiliaire, dans lequel le nombre complexe est sélectionné par le biais récursif :
- de la sélection d'une zone (310) parmi l'ensemble de zones correspondant à un symbole actuel de la sous-chaîne ;
- du partitionnement (320, 330) de ladite zone sélectionnée pour obtenir un ensemble de sous-zones correspondant à un agencement géométrique de zones dans l'ensemble de zones ; et
- de la sélection d'une sous-zone parmi l'ensemble de sous-zones correspondant à un symbole suivant de la sous-chaîne ;
dans lequel le nombre complexe pour représenter la sous-chaîne est sélectionné sur la base d'une coordonnée dans le système de coordonnées 2D d'une dernière sous-zone sélectionnée pour un dernier symbole de la sous-chaîne, par exemple sur la base d'un centroïde de la dernière sous-zone ; et
- facultativement, de la génération d'une représentation binaire du nombre complexe pour la transmission au récepteur.

4. Procédé (400) selon la revendication 3, comprenant en outre :
- la détermination d'une fréquence d'un modèle de données respectif dans les données de capteur pour obtenir une fréquence d'un symbole correspondant parmi l'alphabet auxiliaire ; et
- la détermination d'une taille relative de chaque zone dans l'ensemble de zones sur la base de la fréquence, par exemple proportionnellement à la fréquence.

5. Procédé (400) selon la revendication 4, comprenant en outre la sélection initiale d'une taille relative de chaque zone dans l'ensemble de zones pour qu'elle soit égale et l'ajustement de la taille relative durant l'encodage sur la base de fréquences observées de modèles de données respectifs.

6. Procédé (400) selon l'une quelconque des revendications 3 à 5, comprenant en outre la sélection de l'alphabet auxiliaire en utilisant une technique d'apprentissage machine, dans lequel la technique d'apprentissage machine est entraînée pour sélectionner des symboles respectifs de l'alphabet auxiliaire de telle sorte qu'une représentation binaire de la chaîne de symboles a une longueur binaire minimum dans une base complexe dans laquelle la représentation binaire du nombre complexe est généré.

7. Procédé (400) selon l'une quelconque des revendications 3 à 6, comprenant en outre la sélection d'une base complexe dans laquelle une représentation binaire du nombre complexe est générée en utilisant une technique d'apprentissage machine, dans lequel la technique d'apprentissage machine est entraînée pour sélectionner la base complexe de telle sorte que la représentation binaire du nombre complexe a une longueur binaire minimum dans la base complexe.

8. Procédé (400) selon l'une quelconque des revendications 1 à 7, dans lequel la technique de détection d'objet est configurée pour détecter et classifier l'objet dans les données de capteur pour obtenir une classification d'objet en tant qu'attribut de l'objet.

9. Procédé (400) selon l'une quelconque des revendications 1 à 8, dans lequel les données de capteur comprennent ou sont représentables sous forme de série ou de groupe de nombres complexes, par exemple sous forme d'amplitude et de phase.

10. Procédé (400) selon l'une quelconque des revendications 1 à 9, dans lequel les données de capteur comprennent ou sont un groupe d'éléments de données de capteur, par exemple sous forme d'image.

11. Procédé mis en œuvre par ordinateur (500) de décodage de données de capteur reçues en provenance d'un envoyeur, comprenant :
- la réception (510) de données de capteur encodées en provenance de l'envoyeur ;
- la réception (520) de données d'objet en provenance de l'envoyeur, dans lequel les données d'objet sont indicatives d'un ou plusieurs attributs d'un objet qui est détectable dans les données de capteur ; et
- le décodage (530) des données de capteur encodées pour obtenir des données de capteur décodées, dans lequel le décodage comprend l'application d'une technique de décompression de données aux données de capteur encodées, dans lequel la technique de décompression de données est configurable par un ou plusieurs paramètres de décompression, dans lequel l'application de la technique de décompression de données aux données de capteur encodées comprend la sélection d'au moins un de l'un ou des plusieurs paramètres de décompression sur la base de l'un ou des plusieurs attributs de l'objet, dans lequel les données de capteur encodées comprennent une représentation binaire d'une chaîne de symboles représentant les données de capteur, dans lequel les symboles dans la chaîne de symboles sont sélectionnés parmi un alphabet auxiliaire pour représenter des modèles de données différents dans les données de capteur, dans lequel le décodage des données de capteur encodées comprend le décodage de la représentation binaire de la chaîne de symboles pour obtenir la chaîne de symboles, dans lequel un modèle de décision est utilisé pour la prise de décision dans le décodage, dans lequel la sélection de l'au moins un de l'un ou des plusieurs paramètres de décompression comprend la sélection du modèle de décision sur la base de l'un ou des plusieurs attributs de l'objet, par exemple en sélectionnant un modèle de décision différent pour des valeurs différentes d'un attribut de l'objet.

12. Support transitoire ou non transitoire lisible par ordinateur (600) comprenant des données (610) représentant des instructions qui, lorsqu'elles sont exécutées par un système processeur, amènent le système processeur à réaliser le procédé mis en œuvre par ordinateur selon l'une quelconque des revendications 1 à 11.

13. Dispositif envoyeur (100) comprenant un sous-système processeur (140), une interface de capteur (120) pour un capteur (110), et une interface de communication (180) pour un dispositif récepteur, dans lequel le dispositif envoyeur est configuré pour réaliser le procédé selon l'une quelconque des revendications 1 à 10.

14. Dispositif récepteur (200) comprenant un sous-système processeur (240) et une interface de communication (220) pour un dispositif envoyeur, dans lequel le dispositif récepteur est configuré pour réaliser le procédé selon la revendication 11.

15. Réseau de capteur distribué comprenant un dispositif envoyeur (100) selon la revendication 13 et un dispositif récepteur (200) selon la revendication 14, dans lequel le dispositif envoyeur est, par exemple, un dispositif capteur et le dispositif récepteur est, par exemple, un dispositif de traitement de données de capteur.
